# EUROPEAN PATENT APPLICATION

(11) **EP 1 385 202 A2**
(43) Date of publication of application: **28.01.2004**
(21) Application number: 03016803.3
(22) Date of filing: 23.07.2003
(51) Int. Cl.: H01L 21/768

(54) **Method for manufacturing a via hole of a semiconductor device**

(30) Priority: 25.07.2002 JP 2002216458
(71) Applicant: MATSUSHITA ELECTRIC INDUSTRIAL CO., LTD., Kadoma-shi, Osaka 571-8501 (JP)
(72) Inventor: Tarumi, Nobuaki, Takatsuki-shi, Osaka 569-1143 (JP); Ikeda, Atsushi, Arai-shi, Niigata 944-0008 (JP); Kishida, Takenobu, Settsu-shi, Osaka 566-0011 (JP)
(74) Representative: Grünecker, Kinkeldey, Stockmair & Schwanhäusser Anwaltssozietät

(57) **Abstract**

A lower barrier layer made of tantalum nitride (19) having a thickness of approximately 25nm is deposited by sputtering on an insulating film (17) inclusive of the sidewall surfaces and the bottom surfaces of a via hole (17a) and an upper-interconnect-forming groove (18a). The sputtering is performed under the conditions where approximately 10kW of DC source power is applied to a target. Thereafter, the DC source power is reduced to approximately 2kW, and approximately 200W of RF power is applied to a semiconductor substrate. Here, the lower barrier layer is subjected to a sputter-etching process employing argon gas at an etching amount of approximately 5nm, so that a part of the lower barrier layer deposited on the bottom surface of the via hole is at least partially deposited on the lower part of the sidewall surface of the via hole.

## Description

### BACKGROUND OF THE INVENTION

The present invention relates to a method for manufacturing a semiconductor device including metal interconnects, and more particularly to a method for manufacturing a semiconductor device including metal interconnects by using a dual damascene method.

In recent years, miniaturization and multilayering of interconnects have been advanced for the purpose of achieving higher packing densities of semiconductor devices.

Hereinafter, a known method of forming multilayer metal interconnects for a semiconductor device will be described with reference to the drawings.

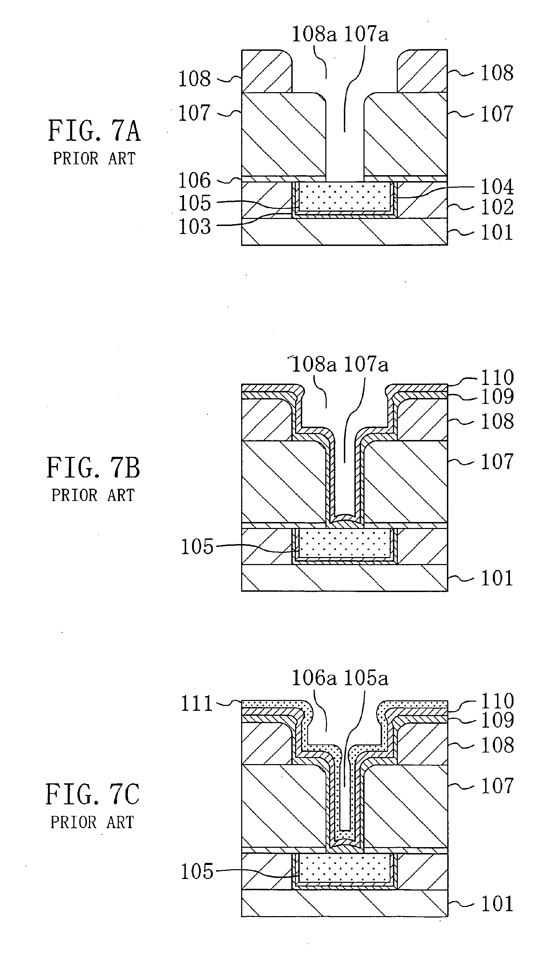

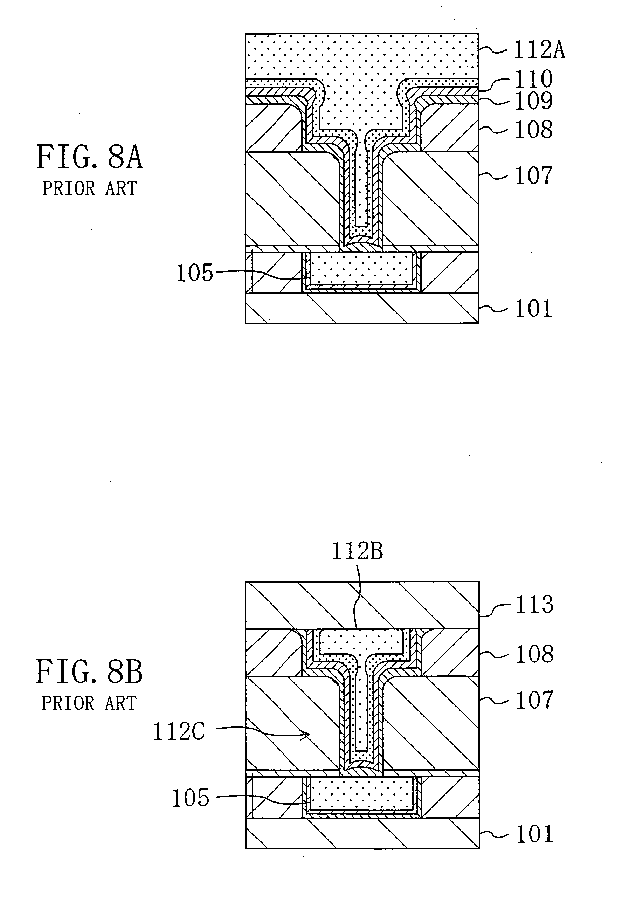

Figures **7A** through **7C, 8A,** and **8B** illustrate the known method for manufacturing a semiconductor device, wherein respective cross-sectional structures of part of multilayer interconnects including a via hole are shown in the order of process steps.

Initially, as shown in Figure **7A**, a first insulating film **101** and a second insulating film **102** each made of silicon oxide or the like are successively deposited on a semiconductor substrate (not shown). Subsequently, a lower-interconnect-forming groove is formed in a predetermined region of the second insulating film **102**. A first barrier film **103** made of tantalum nitride and a second barrier film **104** made of tantalum are formed in the formed lower-interconnect-forming groove, and a lower interconnect **105** made of copper is then formed to fill in the lower-interconnect-forming groove with the first and second barrier films **103** and **104** interposed therebetween. Thereafter, a third insulating film **106** made of silicon nitride, a fourth insulating film **107** made of silicon oxide and a fifth insulating film **108** are successively deposited. Subsequently, an upper-interconnect-forming groove **108a** is formed in a region of the fifth insulating film **108** above the lower interconnect **105**. Then, a via hole **107a** exposing the lower interconnect **105** is selectively formed in regions of the third and fourth insulating films **106** and **107** below the upper-interconnect-forming groove **108a**.

Next, as shown in Figure **7B,** a first barrier film **109** made of tantalum nitride and a second barrier film **110** made of tantalum are successively deposited on the fifth insulating film **108** over the whole area inclusive of the bottom surfaces and the sidewall surfaces of the via hole **107a** and the upper-interconnect-forming groove **108a,** by sputtering or the like.

Next, as shown in Figure **7C,** a plating seed layer **111** made of copper is deposited on the second barrier film **110** over the whole area inclusive of the bottom surfaces and the sidewall surfaces of the via hole **107a** and the upper-interconnect-forming groove **108a,** by sputtering or the like. Thereafter, as shown in Figure **8A,** an upper-interconnect-forming layer **112A** made of copper is buried in the via hole **107a** and the upper-interconnect-forming groove **108a** by electroplating.

Next, as shown in Figure **8B,** part of the upper-interconnect-forming layer **112A** deposited on the fifth insulating film **108** is removed by a chemical mechanical polishing method or the like, and the resultant upper surface is planarized, thereby forming an upper interconnect **112B** and a via **112C** from the upper-interconnect-forming layer **112A.** Thereafter, a sixth insulating film **113** is deposited on the planarized fifth insulating film **108** and the upper interconnect **112B**.

However, when miniaturization in the interconnect is further advanced, the known method for manufacturing a semiconductor device makes it difficult to bury the upper-interconnect-forming layer **112A** in the via hole **107a** by plating.

More particularly, the aspect ratio of the via hole **107a** (the ratio of the depth to the aperture) becomes larger with miniaturization in the interconnect. Therefore, in each of the cases of depositing the first barrier film **109,** the second barrier film **110** and the plating seed layer **111** on the via hole **107a,** sputter atoms are required to have improved linearity (anisotropy).

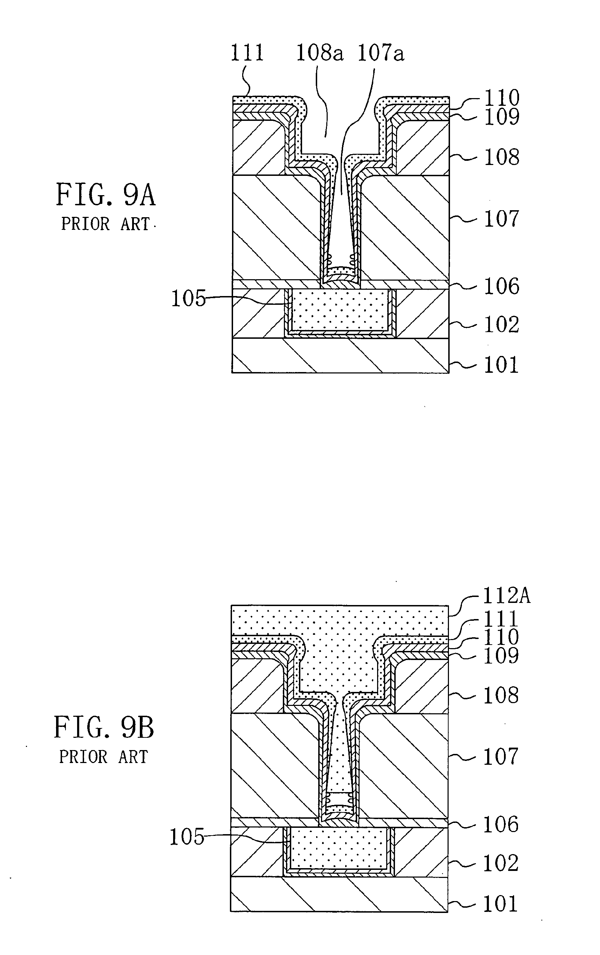

On the other hand, when the linearity of the sputter atoms is increased, as shown in a sputtering step of Figure **9A,** every one of the first barrier film **109,** the second barrier film **110** and the plating seed layer **111** is not sufficiently deposited on the lower part of the sidewall surface of the via hole **107a,** resulting in these films and this layer being thinned. Especially, when the thickness of each of the first barrier film **109** and the second barrier film **110** is small, copper atoms constituting the plating seed layer **111** cohere so that the film to be formed may be non-uniform or discontinuous. Consequently, as shown in a plating step of Figure **9B,** the via hole **107a** is not filled in with the upper-interconnect-forming layer **112A,** and therefore a cavity-shaped defect called a void or a seam **107b** is produced.

In this way, when the upper-interconnect-forming layer **112A** is not surely buried in the via hole **107a,** the resistance of each of the via **112C** and interconnects **105** and **112B** is increased, or electro-migration or stress migration occurs, resulting in significantly reduced reliability of the multilayer interconnects.

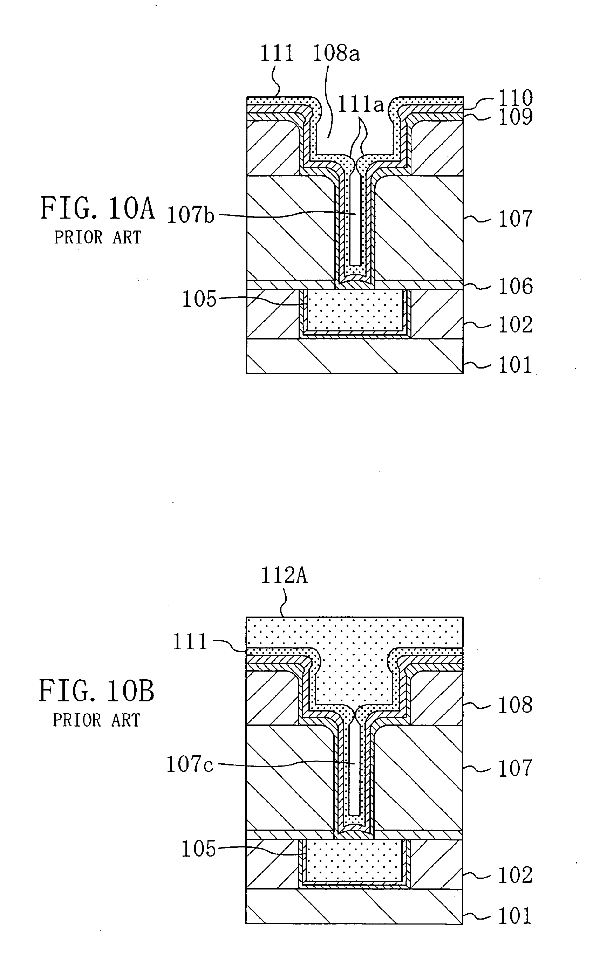

To cope with this, if the thickness of each of the first barrier film **109**, the second barrier film **110** and the plating seed layer **111** is increased, as shown in a sputtering step of Figure **10A,** an overhang portion **111a** formed at the upper end of the opening of the via hole **107a** becomes larger. As a result, in a plating step of Figure **10B,** the almost whole internal part of the via hole **107a** forms a seam **107c.**

### SUMMARY OF THE INVENTION

The present invention has been made to solve the aforementioned problem, and an object of the present invention is to realize metal interconnects with excellent filling characteristics, in which any void or seam is not produced in a miniaturized interconnect-forming groove and via hole.

In order to accomplish the above-mentioned object, the present invention provides for a method for manufacturing a semiconductor device in which an underlying layer is formed in a contact hole by sputtering and a part of the underlying layer deposited on the bottom surface of the contact hole is at least partially deposited on the lower part of the sidewall surface of the contact hole.

More particularly, a method for manufacturing a semiconductor device according to the present invention comprises: a first step of forming an insulating film including a contact hole on a substrate; a second step of forming a conductive underlying layer on the insulating film inclusive of the sidewall surface and the bottom surface of the contact hole; a third step of subjecting the underlying layer to sputter-etching so that a part of the underlying layer deposited on the bottom surface of the contact hole is at least partially deposited on the lower part of the sidewall surface of the contact hole; and a fourth step of forming a metal layer on the underlying layer by plating.

According to the method for manufacturing a semiconductor device of the present invention, since the film thickness of part of the underlying layer deposited on the lower part of the sidewall surface of the contact hole becomes larger, the underlying layer is continuously deposited also on the lower part of the sidewall surface of the contact hole. Consequently, the coverage of the underlying layer is improved in the lower part of the sidewall surface of the contact hole, and therefore step discontinuity (film break) which is easily caused at the corners of the bottom part of the contact hole can be avoided. In addition, an overhang portion formed at the upper end of the opening of the contact hole can be reduced, thereby ensuring an opening area sufficient to bury the metal layer in the contact hole by plating. As a result, the occurrence of a void or a seam inside the contact hole can be prevented, and the filling characteristics of the metal layer can be improved. Thereby, multilayer interconnects for the semiconductor device can be further miniaturized.

Moreover, when the underlying layer is a barrier layer, a portion of the barrier layer which covers the lower part of the sidewall surface of the contact hole is thickened by sputter-etching and the sidewall surface is uniformly covered. Therefore, interface-diffusion of atoms constituting the metal layer, such as copper atoms, into the insulating film can be suppressed. As a result, the resistance against electro-migration or stress migration can be improved.

Moreover, when the underlying layer is a barrier layer, a portion of the underlying layer on the bottom surface of the contact hole is thinned by sputter-etching. Therefore, the diffusion of metal atoms easily occurs between the metal layer filling in the contact hole and the lower interconnect formed under the metal layer. As a result, the occurrence of a void at the bottom part of the contact hole can be suppressed, thereby improving the resistance against electro-migration. Furthermore, since the underlying layer is thinned, the interconnect resistance can be also reduced.

According to the method for manufacturing a semiconductor device of the present invention, the underlying layer is preferably a plating seed layer made of metal, and the plating seed layer and the metal layer contain copper as a main ingredient.

According to the method for manufacturing a semiconductor device of the present invention, the underlying layer is preferably a barrier layer for preventing atoms constituting the metal layer from diffusing into the insulating film, and the method further comprises, between the third step and the fourth step, a fifth step of forming a plating seed layer made of metal on the barrier layer inclusive of the sidewall surface and the bottom surface of the contact hole.

In this case, said method preferably further comprises, between the fifth step and the fourth step, a sixth step of subjecting the plating seed layer to sputter-etching so that a part of the plating seed layer deposited on the bottom surface of the contact hole is at least partially deposited on the lower part of the sidewall surface of the contact hole.

When the underlying layer is a barrier layer, the plating seed layer and the metal layer preferably contain copper as a main ingredient.

When the underlying layer is a barrier layer, in the third step, a portion of the barrier layer deposited on the bottom surface of the contact hole is preferably removed.

Further, when the underlying layer is a barrier layer, the barrier layer is preferably made of high melting point metal or nitride of the high melting point metal.

In this case, it is preferable that the barrier layer comprises a lower barrier layer made of nitride of high melting point metal and an upper barrier layer made of high melting point metal, and that the second and third steps are performed for each of the lower barrier layer and the upper barrier layer.

### BRIEF DESCRIPTION OF THE DRAWINGS

Figures **1A** and **1B** illustrate a method for manufacturing a semiconductor device according to an embodiment of the present invention, and show respective cross-sectional structures of part of multilayer interconnects including a via hole in the order of process steps.
Figures **2A** and **2B** illustrate the method for manufacturing a semiconductor device according to the above embodiment of the present invention, and show respective cross-sectional structures of part of multilayer interconnects including a via hole in the order of process steps.
Figure **3A** and **3B** illustrate the method for manufacturing a semiconductor device according to the above embodiment of the present invention, and show respective cross-sectional structures of part of multilayer interconnects including a via hole in the order of process steps.
Figures **4A** and **4B** illustrate the method for manufacturing a semiconductor device according to the above embodiment of the present invention, and show respective cross-sectional structures of part of multilayer interconnects including a via hole in the order of process steps.
Figures **5A** and **5B** illustrate the method for manufacturing a semiconductor device according to the above embodiment of the present invention, and show respective cross-sectional structures of part of multilayer interconnects including a via hole in the order of process steps.
Figures **6A** and **6B** illustrate the method for manufacturing a semiconductor device according to the above embodiment of the present invention, and show respective cross-sectional structures of part of multilayer interconnects including a via hole in the order of process steps.

Figures **7A** through **7C** illustrate a known method for manufacturing a semiconductor device, and show respective cross-sectional structures of part of multilayer interconnects including a via hole in the order of process steps.

Figures **8A** and **8B** illustrate the known method for manufacturing a semiconductor device, and show respective cross-sectional structures of part of multilayer interconnects including a via hole in the order of process steps.

Figures **9A** and **9B** are cross-sectional views showing respective structures of multilayer interconnects in the order of process steps of the known method for manufacturing a semiconductor device, wherein a defect caused in the via hole is shown.

Figures **10A** and **10B** are cross-sectional views showing respective structures of multilayer interconnects in the order of process steps of the known method for manufacturing a semiconductor device, wherein a defect caused in the via hole is shown.

### DETAILED DESCRIPTION OF THE INVENTION

An embodiment of the present invention will be described with reference to the drawings.

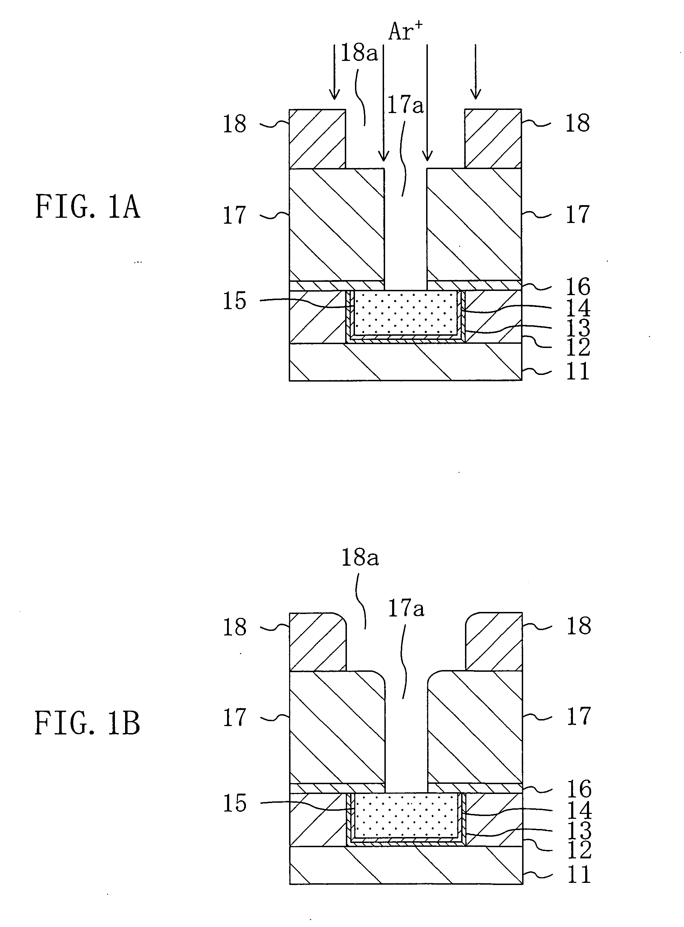

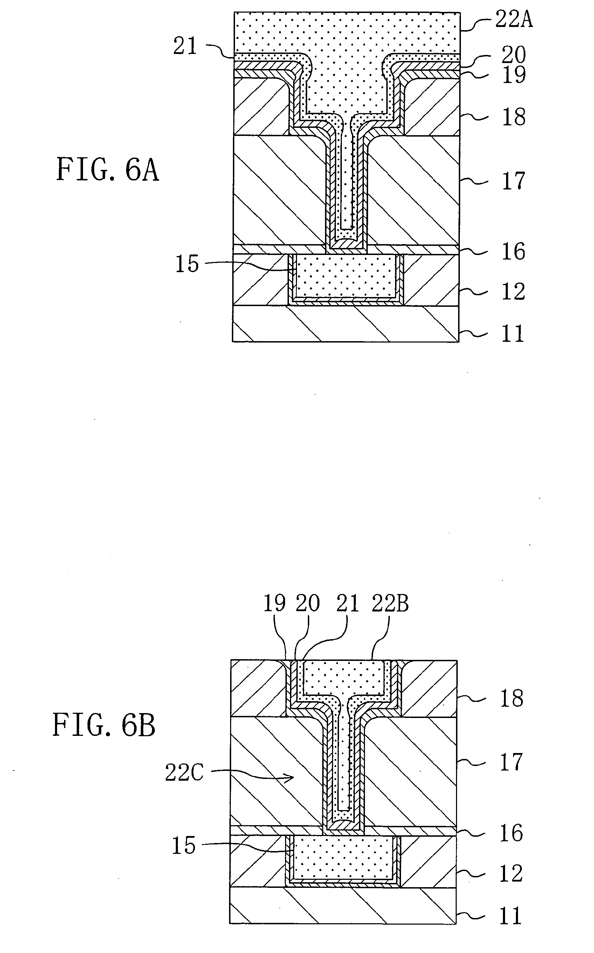

Figures **1A** and **1B** through **6A** and **6B** illustrate a method for manufacturing a semiconductor device according to an embodiment of the present invention, wherein cross-sectional structures of part of multilayer interconnects including a via hole (contact hole) are shown in the order of process steps.

Initially, as shown in Figure **1A**, for example, a first insulating film **11** and a second insulating film **12** which are each made of BPSG (Boron Phosphorous Silicate Glass) obtained by adding boron and phosphorous to silicon oxide are successively deposited on a semiconductor substrate (not shown) made of silicon (Si) by a chemical vapor deposition (CVD) process. Subsequently, a lower-interconnect-forming groove is formed in a predetermined region of the second insulating film **12** by lithography and dry etching. Thereafter, a lower barrier layer **13** made of tantalum nitride (TaN) and an upper barrier layer **14** made of tantalum (Ta) are deposited on the second insulating film **12** over the whole area inclusive of the lower-interconnect-forming groove by sputtering. Subsequently, a plating seed layer (not shown) made of copper (Cu) or an alloy containing copper as a main ingredient is deposited on the upper barrier layer **14** by sputtering. Thereafter, a metal layer made of copper or a copper alloy is deposited on the plating seed layer by electroplating. Then, by chemical mechanical polishing (CMP), parts of the lower barrier layer, the upper barrier layer and the metal layer deposited on the second insulating film **12** are removed, thereby forming a lower interconnect **15** from the metal layer filling in the lower-interconnect-forming groove.

Thereafter, a third insulating film **16** made of silicon nitride (Si₃N₄), a fourth insulating film **17** made of BPSG, and a fifth insulating film **18** made of BPSG are successively deposited by CVD, for example. Subsequently, an upper-interconnect-forming groove **18a** is formed in a region of the fifth insulating film **18** above the lower interconnect **15.** Then, a via hole **17a** exposing the lower interconnect **15** is selectively formed in regions of the third insulating film **16** and the fourth insulating film **17** below the upper-interconnect-forming groove **18a.** Thereafter, sputter-etching is performed employing argon (Ar⁺) gas to remove copper oxide or the like as native oxide formed on the surface of the lower interconnect 15 exposed from the via hole **17a.**

As shown in Figure **1B,** the sputter-etching allows the upper ends of the respective openings of the upper-interconnect-forming groove **18a** and the via hole **17a** to be expanded in a rounded manner. Therefore, the areas of openings are also increased after barrier layers and a plating seed layer are deposited in later steps, resulting in excellent filling characteristics of the metal layer in plating.

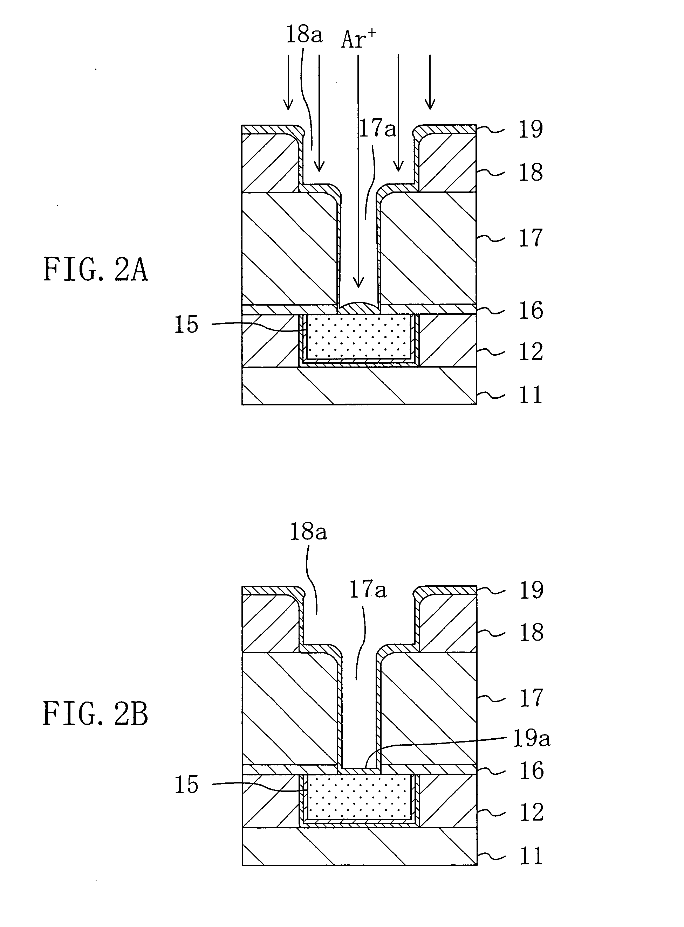

Next, as shown in Figure **2A,** a lower barrier layer **19** made of tantalum nitride having a thickness of approximately 25nm is deposited by sputtering on the fourth insulating film **17** inclusive of the sidewall surfaces and the bottom surfaces of the via hole **17a** and the upper-interconnect-forming groove **18a**. At this time, the sputtering is performed with approximately 10kW of DC source power applied to a target. Thereafter, the DC source power is reduced to approximately 2kW, and approximately 200W of RF power is applied to the semiconductor substrate (sample). Here, the lower barrier layer **19** is subjected to a sputter-etching process employing argon gas at an etching amount of approximately 5nm. Thereby, as shown in Figure **2B,** a part of the lower barrier layer **19** deposited on the bottom surface of the via hole **17a** is at least partially deposited on the lower part of the sidewall surface of the via hole **17a**. The lower barrier layer **19** made of tantalum nitride is provided for the purpose of preventing copper atoms constituting an upper interconnect and a via formed in a later step from diffusing into the fourth insulating film **17** and the fifth insulating film **18.** Thereby, the lower barrier layer **19** which prevents the copper atoms from diffusing becomes thicker as its coverage is improved in at least the lower part of the sidewall surface of the via hole **17a.**

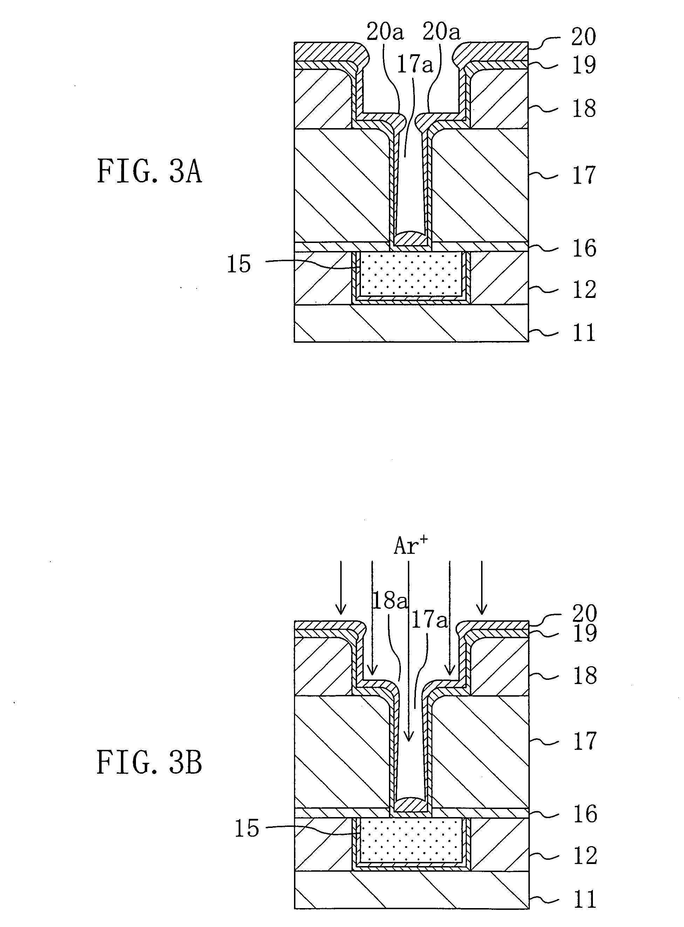

Next, as shown in Figure **3A,** an upper barrier layer **20** made of β-tantalum (β-Ta) having a thickness of approximately 10nm is deposited by sputtering on the lower barrier layer **19** inclusive of the sidewall surfaces and the bottom surfaces of the via hole **17a** and the upper-interconnect-forming groove **18a**. At this time, the sputtering is performed with approximately 10kW of DC source power applied to the target as in the lower barrier layer **19**. Here, the upper barrier layer **20** made of tantalum is provided as an underlying layer for the plating seed layer formed in a later step. The upper barrier layer **20** allows the adhesion between the plating seed layer and each of the fourth insulating film **17** and the fifth insulating film **18** to be improved. Further, it has been found that β-tantalum has more excellent adhesion to copper (Cu) than that of α-tantalum.

As described above, when the semiconductor device is miniaturized, the aspect ratio of the via hole **17a** becomes larger. Therefore, in order that each of the lower barrier layer **19** and the upper barrier layer **20** obtains a sufficient thickness of approximately 3 to 5nm also in the lower part of the sidewall surface of the via hole **17a**, each layer must be deposited on the upper surfaces of the fourth insulating film **17** and the fifth insulating film **18** to a thickness of 30 to 50nm. Consequently, as shown in Figure **3A**, an overhang portion **20a** is formed at the upper end of the opening of the via hole **17a**, and therefore the opening area of the via hole 17a is reduced.

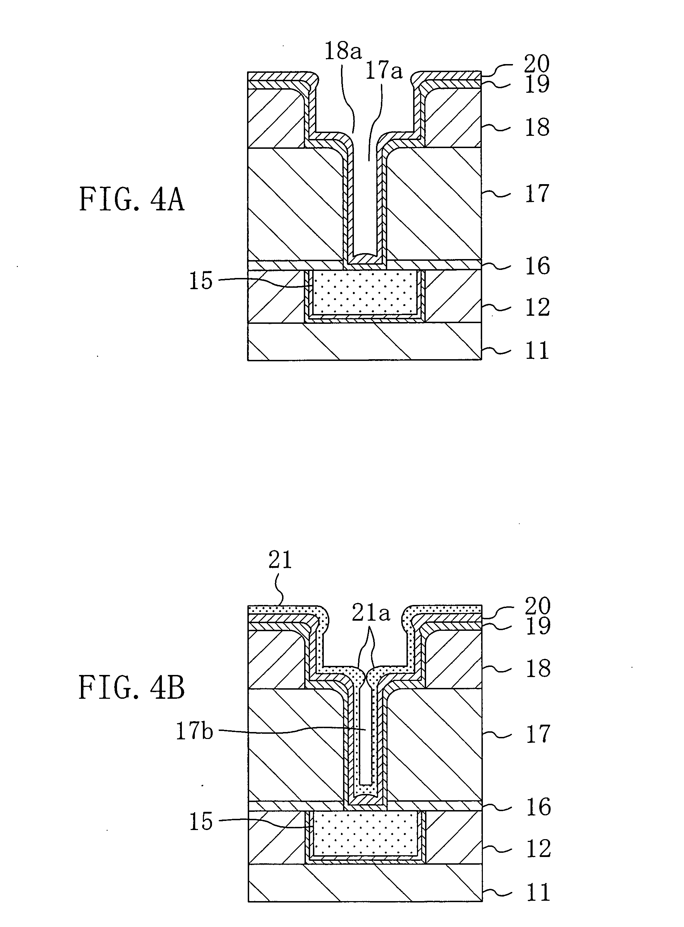

To cope with this, in the next step shown in Figure **3B**, the DC source power is reduced to approximately 2kW, and appropriately 200W of RF power is applied to the semiconductor substrate. Here, the upper barrier layer **20** is subjected to a sputter-etching process employing argon gas at an etching amount of approximately 5nm. As shown in Figure **4A**, the sputter-etching allows a part of the upper barrier layer **20** deposited on the bottom surface of the via hole **17a** to be at least partially deposited on the lower barrier layer **19** in the lower part of the sidewall surface of the via hole **17a**. Thereby, the upper barrier layer **20** as the underlying layer for the plating seed layer becomes thicker as its coverage is improved in at least the lower part of the sidewall surface of the via hole **17a**.

In this way, according to this embodiment, the coverage of each of the lower barrier layer **19** and the upper barrier layer **20** in the lower part of the sidewall surface of the via hole **17a** can be improved- by the anisotropic sputter-etching process which is performed after deposition. Therefore, even when the initial film thickness of each of the deposited barrier layers **19** and **20** is reduced, the barrierability of the lower barrier film **19** against copper atoms and the adhesion of the upper barrier layer **20** to the plating seed layer can be ensured.

Moreover, with respect to each of the barrier layers **19** and **20**, the sputter-etching process after deposition can also reduce the film thickness of a part of each layer deposited on the upper surfaces of the fourth insulating film **17** and the fifth insulating film **18,** and therefore the overhang portion at the upper end of the opening can be reduced. Simultaneously, the film thickness of part of each of the barrier layers **19** and **20** on the bottom surface of the via hole **17a** can be also reduced, and therefore the via interconnect resistance can be reduced. Accordingly, the sputter-etching is performed for each of barrier layers **19** and **20** to the extent that a portion of each of them on the bottom surface of the via hole **17a** is removed, thereby further reducing the via interconnect resistance.

Next, as shown in Figure **4B**, by a sputtering method in which approximately 30kW of DC source power is applied to the target, a plating seed layer **21** made of copper having a thickness of approximately 100nm or an alloy containing copper as the main ingredient is deposited on the upper barrier layer **20** inclusive of the sidewall surfaces and the bottom surfaces of the via hole **17a** and the upper-interconnect-forming groove **18a.** In order that the plating seed layer **21** obtains a sufficient thickness of approximately 10 to 15nm also in the lower part of the sidewall surface of the via hole **17a** like the barrier layers **19** and **20,** the plating seed layer **21** must be deposited on the fifth insulating film **18** to a thickness of approximately 100 to 150nm. Consequently, as shown in Figure **4B,** an overhang portion **21a** is formed at the upper end of the opening of the via hole **17a**, and therefore the opening area of the via hole **17a** is reduced. In an extreme case, a seam **17b** is formed in this step. Further, since the plating seed layer **21** constitutes an underlying layer for copper plating in a later plating step, the plating seed layer **21** must be continuously formed without interruption on the semiconductor substrate. Therefore, if the plating seed layer **21** were not continuously formed, a void or the like would be produced in the lower part of the via hole in the plating step as shown in Figure **9B**.

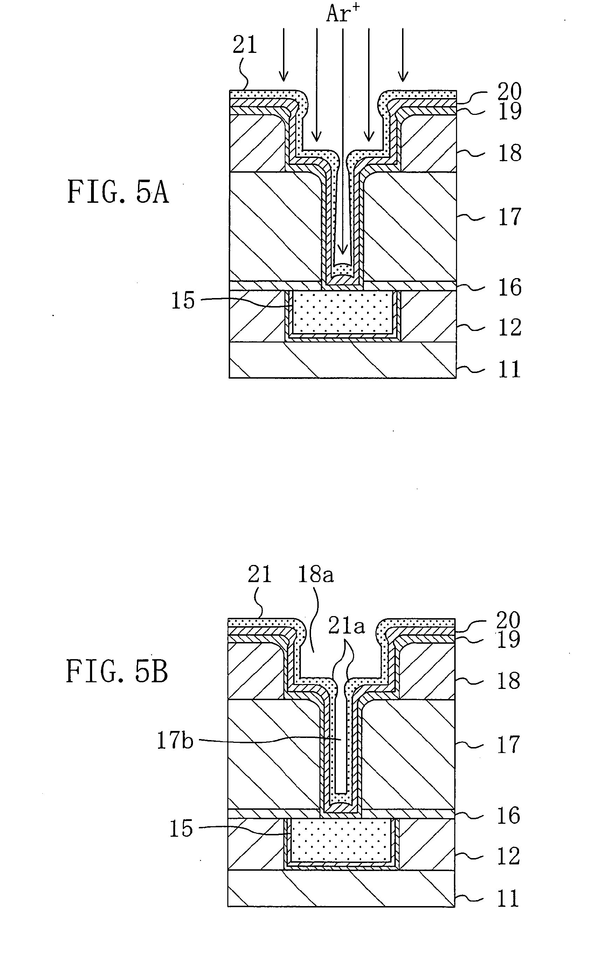

To avoid this, in the next step shown in Figure **5A**, the DC source power is set at approximately 2kW, and approximately 200W of RF power is applied to the semiconductor substrate. Here, the plating seed layer **21** is subjected to a sputter-etching process employing argon gas at an etching amount of approximately 50nm. As shown in Figure **5B,** the sputter-etching allows a part of the plating seed layer **21** deposited on the bottom surface of the via hole **17a** to be at least partially deposited on the lower barrier layer **19** in the lower part of the sidewall surface of the via hole **17a.** Thereby, the plating seed layer **21** as the underlying layer for plating has the coverage improved in at least the lower part of the sidewall surface of the via hole **17a.** Moreover, since the film thickness of each of portions of the plating seed layer **21** located on the fourth insulating film **17** and the fifth insulating film **18** is reduced, the overhanging amount of the overhang portion **21a** at the upper end of the opening of the via hole **17a** becomes smaller. As a result, an aperture required for copper plating in a later step can be ensured in the via hole **17a**.

Next, as shown in Figure **6A**, an upper-interconnect-forming layer **22A** made of copper is buried in the via hole **17a** and the upper-interconnect-forming groove **18a** by electroplating.

Next, as shown in Figure **6B,** part of the upper-interconnect-forming layer **22A** deposited on the fifth insulating film **18** is removed by CMP or the like, and the resultant top surface is planarized, thereby forming an upper interconnect **22B** and a via **22C** from the upper-interconnect-forming layer **22A** made of copper.

While in this embodiment the lower barrier layer **19** and the upper barrier layer **20** interposed between the plating seed layer **21** and both of the fourth insulating film **17** and the fifth insulating film **18** form a laminated structure made of tantalum nitride (TaN) and tantalum (Ta), the present invention is not restricted thereto. For example, the lower barrier layer **19** may be of tungsten nitride (WN), and the upper barrier layer **20** may be of tungsten (W). Alternatively, the other high melting point metals or their nitrides may be employed for the barrier layers. In addition, the barrier layers **19** and **20** are not necessarily required to form a laminated structure.

Moreover, while copper is employed as a metal material constituting the lower interconnect **15**, the upper interconnect **22B** and the via **22C**, the present invention is not restricted thereto, but a metal such as aluminum (Al) or silver (Ag) or an alloy thereof may be employed.

Furthermore, while the lower barrier layer **19**, the upper barrier layer **20** and the plating seed layer **21** are deposited by the sputtering method, the present invention is not restricted thereto, but the CVD method may be employed to deposit the layers.

## Claims

1. A method for manufacturing a semiconductor device comprising:
a first step of forming an insulating film including a contact hole on a substrate;
a second step of forming a conductive underlying layer on the insulating film inclusive of the sidewall surface and the bottom surface of the contact hole;
a third step of subjecting the underlying layer to sputter-etching so that a part of the underlying layer deposited on the bottom surface of the contact hole is at least partially deposited on the lower part of the sidewall surface of the contact hole; and
a fourth step of forming a metal layer on the underlying layer by plating.

2. The method for manufacturing the semiconductor device of Claim 1 wherein
the underlying layer is a plating seed layer made of metal, and
the plating seed layer and the metal layer contain copper as a main ingredient.

3. The method for manufacturing a semiconductor device of Claim 1 wherein
the underlying layer is a barrier layer for preventing atoms constituting the metal layer from diffusing into the insulating film, and
the method further comprises, between the third step and the fourth step, a fifth step of forming a plating seed layer made of metal on the barrier layer inclusive of the sidewall surface and the bottom surface of the contact hole.

4. The method for manufacturing a semiconductor device of Claim 3, said method further comprising, between the fifth step and the fourth step, a sixth step of subjecting the plating seed layer to sputter-etching so that a part of the plating seed layer deposited on the bottom surface of the contact hole is at least partially deposited on the lower part of the sidewall surface of the contact hole.

5. The method for manufacturing a semiconductor device of Claim 3 wherein the plating seed layer and the metal layer contain copper as a main ingredient.

6. The method for manufacturing a semiconductor device of Claim 3 wherein in the third step, a portion of the barrier layer deposited on the bottom surface of the contact hole is removed.

7. The method for manufacturing a semiconductor device of Claim 3 wherein the barrier layer is made of high melting point metal or nitride of the high melting point metal.

8. The method for manufacturing a semiconductor device of Claim 3 wherein the barrier layer comprises a lower barrier layer made of nitride of high melting point metal and an upper barrier layer made of high melting point metal, and
the second and third steps are performed for each of the lower barrier layer and the upper barrier layer.
